# EUROPEAN PATENT SPECIFICATION

(11) **EP 3 423 932 B1**
(45) Date of publication and mention of the grant of the patent: **05.05.2021**
(21) Application number: 17760425.3
(22) Date of filing: 16.01.2017
(51) Int. Cl.: G06F 3/06, G11C 7/10

(54) **TECHNIQUES FOR COMMAND BASED ON DIE TERMINATION**
VERFAHREN FÜR BEFEHLSBASIERTE TERMINIERUNG AUF DEM CHIP
TECHNIQUES DE COMMANDE BASÉE SUR TERMINAISON SUR PUCE

(30) Priority: 04.03.2016 US 201662303707 P; 01.07.2016 US 201615200981
(43) Date of publication of application: 09.01.2019
(73) Proprietor: Intel Corporation, Santa Clara, CA 95054 (US)
(72) Inventor: COX, Christopher E., Placerville, California 95667 (US); BAINS, Kuljit S., Olympia, Washington 98516 (US); MCCALL, James A., Portland, Oregon 97229 (US)
(74) Representative: Rummler, Felix
(86) International application number: PCT/US2017/013658
(87) International publication number: WO 2017/151229

(56) References cited:
- EP-A1- 2 075 703
- US-A1- 2008 164 904
- US-A1- 2010 027 356
- US-A1- 2010 208 535
- US-A1- 2011 141 841
- US-A1- 2012 206 165
- US-A1- 2014 244 922

## Description

### TECHNICAL FIELD

Examples described herein are generally related to techniques for on die termination at a memory device.

### BACKGROUND

In some memory systems coupled with a host computing device, multiple on die termination (ODT) pins are provided to control values for internal resistance termination (RTT) and on and off timing for ODT. These ODT pins typically require cooperation between the host computing device and a memory device to account for an appropriate amount of time for RTT during a read or write operation to the memory device. An ODT signal is often one of the largest components of turn-around time delay or latency between read or write operations.

US2010/208535A1 relates to a semiconductor device including a skew detecting circuit activated in a write leveling mode, and an ODT control circuit that activates a terminating resistance circuit connected to a data strobe terminal by using an ODT signal. The ODT control circuit includes counters that delay the ODT signal, activates the terminating resistance circuit by using the ODT signal having passed the counters in a normal operation mode, and activates the terminating resistance circuit by using the ODT signal having bypassed the counters in the write leveling mode.

US2014/244922A1 relates to using Per DRAM Addressability (PDA) to program Multi-Purpose Registers (MPRs) of a dynamic random access memory (DRAM) device are described herein.

### SUMMARY

The invention is defined in the claims. In the following description, any embodiment referred to and not falling within the scope of the claims is merely an example useful to the understanding of the invention.

### BRIEF DESCRIPTION OF THE DRAWINGS

FIG. 1 illustrates an example memory device.
FIG. 2 illustrates an example first register coding scheme.
FIG. 3 illustrates an example second register coding scheme.
FIG. 4 illustrates an example first timing diagram.
FIG. 5 illustrates an example second timing diagram.
FIG. 6 illustrates an example third timing diagram.
FIG. 7 illustrates an example block diagram for an apparatus.
FIG. 8 illustrates an example of a logic flow.
FIG. 9 illustrates an example of a storage medium.
FIG. 10 illustrates an example computing platform.

### DETAILED DESCRIPTION

As contemplated in the present disclosure, an ODT signal is often one of the largest components of turn-around time delay or latency between read or write operations at a memory device. Also, ODT pins that were previously provided to a host computing device coupled with a memory device to adjust RTT and on/off time for ODT are being removed for new memory technologies being developed to include, but not limited to, DDR5 (DDR version 5, currently in discussion by JEDEC), LPDDR5 (LPDDR version 5, currently in discussion by JEDEC), HBM2 (HBM version 2, currently in discussion by JEDEC), and/or other new technologies based on derivatives or extensions of such specifications. Since the ODT pins are being removed, logic is being enabled at a memory device to allow for ODT related settings and/or adjustments to improve signal integrity for the memory device during read or write operations. It is with respect to the above-mentioned and other challenges that the examples described herein are needed.

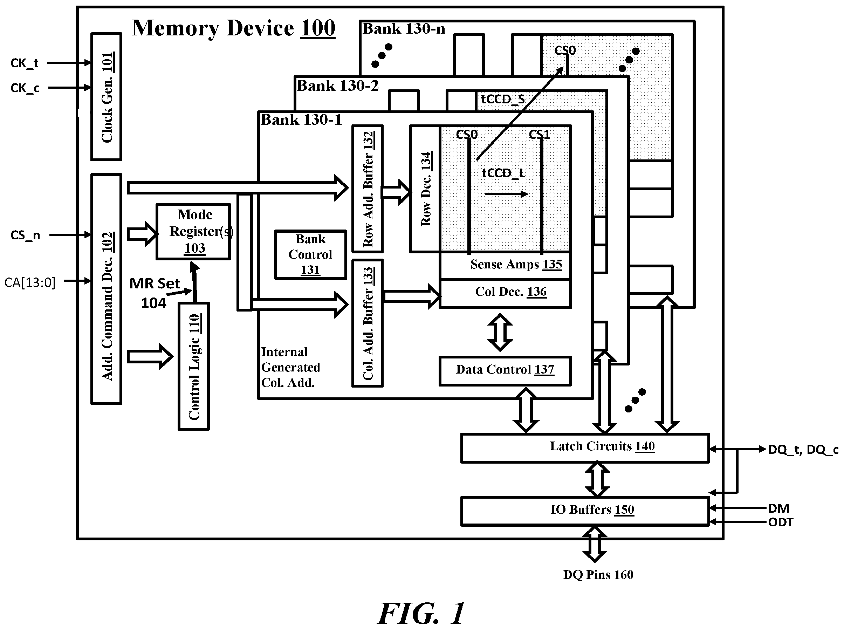

**FIG. 1** illustrates an example memory device 100. In some examples, as shown in FIG. 1, memory device 100 includes various logic, features or circuits to access banks 130-1 to 130*-n* (where "n" is any whole positive integer > 2) responsive to received commands. For example, memory device 100 may include peripheral circuitry to access banks 130-1 to 130-n that includes a clock generator 101, an address command decoder 102, one or more pattern register(s) 103, a control logic 110, latch circuits 140, IO buffers 150 or DQ pins 160. Also, each bank of banks 130-1 to 130-n may separately include a bank control 120, a row address buffer 123, a column address buffer 121, a row decoder 123, sense amps 125, a column decoder 122 or data control 127.

According to some examples, control logic 110 may include logic and/or features capable of programming values to one or more mode register(s) 103 and use the value to adjust RTT values for memory device 100 or adjust one or more values for timing of ODT latency to turn on or turn off respective RTT values ("tODTLon/off") for memory device 100. For these examples, a command may be received through address command decoder 102 that includes information to program the values to the one or more mode register(s) 103. As described more below various values programed to mode register(s) 103 may be based on one or more coding schemes for programming the values to the one or more mode register(s) 103. The values may enable logic at memory device 100 such as control logic 110 to make ODT related settings and/or adjustments to improve signal integrity for memory device 100 during read or write operations, e.g., reduce bit errors by adjusting resistance values or timing values across a data bus.

In some examples, a memory device 100 may include non-volatile types of memory such as DRAM memory. The DRAM memory may be arranged to operate according to various developed memory technologies that may include, but are not limited to, DDR4 (double data rate (DDR) version 4, initial specification published in September 2012 by JEDEC), LPDDR4 (LOW POWER DOUBLE DATA RATE (LPDDR) version 4, JESD209-4, originally published by JEDEC in August 2014), WIO2 (Wide I/O 2 (WideIO2), JESD229-2, originally published by JEDEC in August 2014), HBM (HIGH BANDWIDTH MEMORY DRAM, JESD235, originally published by JEDEC in October 2013), and/or other technologies based on derivatives or extensions of such specifications. Memory device 100 may also include memory arranged to operate according to the above mentioned memory technologies currently in development that may include, but are not limited to, DDR5, LPDDR5 or HBM2.

Although example types of memory included in memory device 100 have been described as including volatile types of memory such as DRAM, this disclosure is not limited to DRAM. In some examples other volatile types of memory including, but not limited to, double data rate synchronous dynamic RAM (DDR SDRAM), static random-access memory (SRAM), thyristor RAM (T-RAM) or zero-capacitor RAM (Z-RAM) are contemplated by this disclosure. Also, block addressable, non-volatile types of memory, such as those associated with NAND or NOR technologies are contemplated by this disclosure. Also, other non-volatile types of memory such as 3-D cross-point memory that are byte addressable are contemplated by this disclosure. These block addressable or byte addressable non-volatile types of memory may include, but are not limited to, non-volatile types of memory that use chalcogenide phase change material (e.g., chalcogenide glass), multi-threshold level NAND flash memory, NOR flash memory, single or multi-level phase change memory (PCM), resistive memory, nanowire memory, ferroelectric transistor random access memory (FeTRAM), magnetoresistive random access memory (MRAM) memory that incorporates memristor technology, or spin transfer torque MRAM (STT-MRAM), or a combination of any of the above, or other non-volatile memory types.

According to some examples, memory device 100 may be one of multiple memory devices or dies included on a dual in-line memory module (DIMM). The DIMM may be designed to function as a registered DIMM (RDIMM), a load reduced DIMM (LRDIMM), a fully-buffered DIMM (FB-DIMM), an unbuffered DIMM (UDIMM) or a small outline (SODIMM). Examples are not limited to only these DIMM designs.

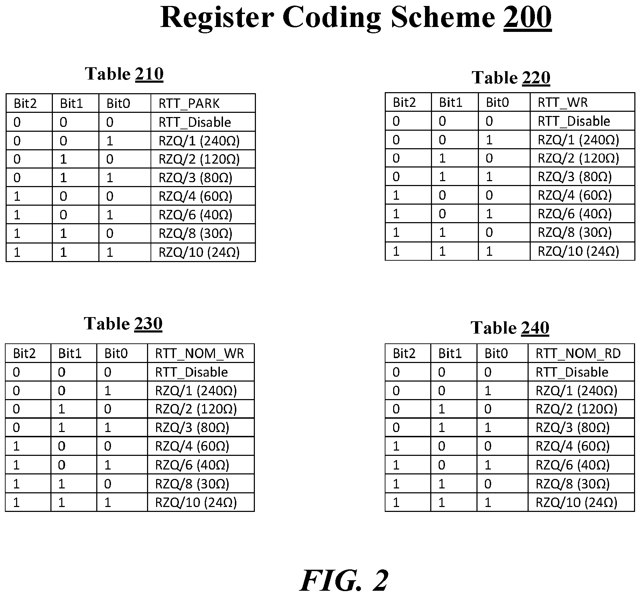

**FIG. 2** illustrates an example register coding scheme 200. In some examples, example coding scheme 200 may include 3-bit values to program various RTT settings for a memory device such as memory device 100. As shown in FIG. 2, table 210 includes programmable settings for RTT PARK, table 220 for RTT WR (WR = write), table 230 for RTT_NOM_WR and table 240 for RTT_NOM_RD (RD = read). For these examples, values related to various resistance setting (e.g., external resistance (RZQ)) in units of ohms may be programed (e.g., by control logic 110) to one or more registers for a memory device such as mode register(s) 103 of memory device 100 may be programmed to mode register(s) 103 based on tables 210, 220, 230 or 240. The values included in each of these tables may then be used (e.g., by control logic 110) to adjust values for RTT PARK, RTT_WR, RTT_NOM_WR or RTT_NOM_RD to improve or optimize signal integrity for the memory device during read or write operations.

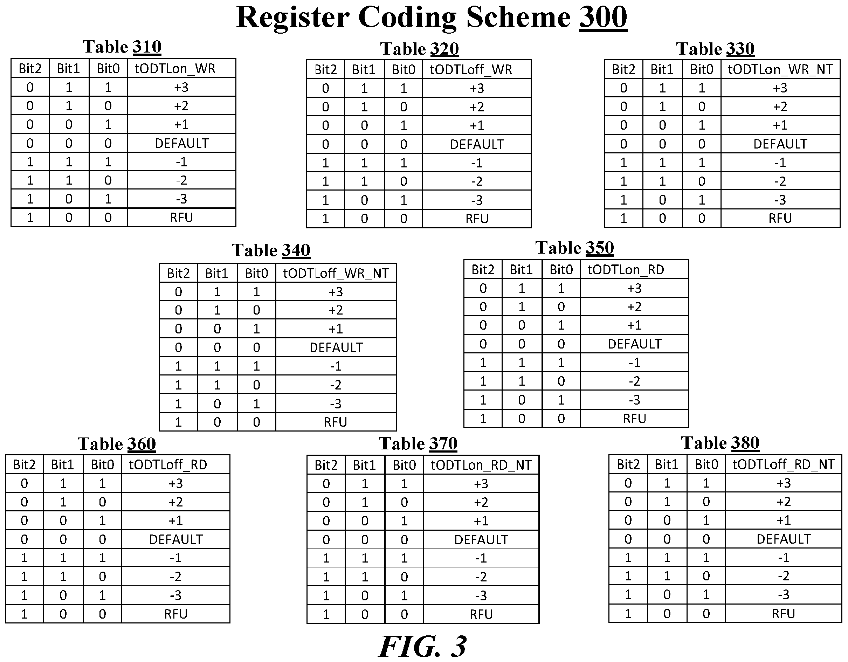

**FIG. 3** illustrates an example register coding scheme 300. In some examples, example coding scheme 300 may include 3-bit values to program various tODTLon/off settings for a memory device such as memory device 100. As shown in FIG. 3, table 310 includes programmable settings for tODTLon _WR, table 320 for tODTLoff_WR, table 330 for tODTLofC_WR_NT (NT = non-target), table 340 for tODTLoff_WR_NT, table 350 for tODTLon_RD, table 360 for tODTLoff_RD, table 370 for tODTLon_RD_NT and table 380 for tODTLoff_RD_NT. For these examples, the values in these tables may be adjustments to various default settings for tODTL based on a clock unit that may be a portion of a clock cycle, a single clock cycle, or multiple clock cycles. The adjustments may push-out (+ values) or pull-in (- values) settings for tODTLon/off that may be programmed (e.g., by control logic 110) to one or more registers for a memory device such as mode register(s) 103 of memory device 100. As described in more detail below, the values may then be used (e.g., by control logic 110) to adjust settings for tODTLon WR, tODTLoff_WR, tODTLoff WR NT, tODTLoff WR NT, tODTLon RD, tODTLoff RD, tODTLon_RD_NT or tODTLoff RD NT to improve or adjust signal integrity for the memory device during read or write operations.

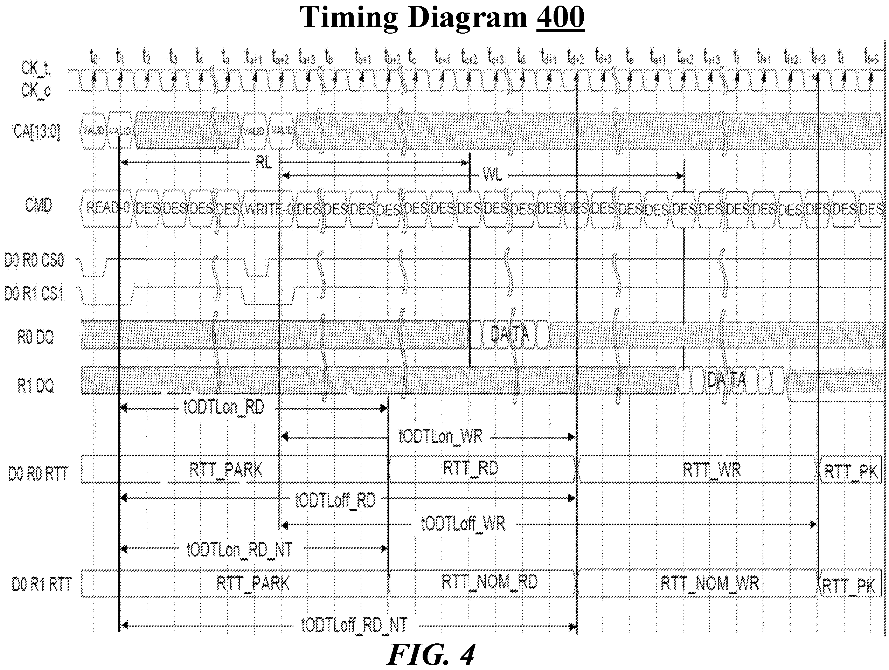

**FIG. 4** illustrates an example timing diagram 400. In some examples, timing diagram 400 as shown in FIG. 4 depicts timing for a read to write turn around for a same rank from among two different ranks. For these examples, the two different ranks may be for a DIMM (D0) and are shown as R0 and R1. At least some elements of memory device 100 shown in FIG. 1 may be used to describe actions taken in relation to timing diagram 400. Examples are not limited to elements of memory device 100 for timing diagram 400.

In some examples, values to establish settings for RTT PARK, RTT WR, RTT_NOM_WR and RTT_NOM_RD may be programmed or stored to mode register(s) 103 for a memory device included in R0 or R1. These values may be changed via programming of different values maintained in mode register(s) according to respective tables 210, 220, 230 and 240 of register coding scheme 200 as shown in FIG. 2 in order to adjust or improve a signal integrity for the memory device. For example, RZQ values for RTT_NOM_RD for D0 of R1 may include mode registers such as mode register(s) 103 being initially programmed based on table 240 to have a resistance setting of 80 ohms that may be negatively impacting signal integrity for memory devices included in R0 during read operations. In order to improve signal integrity for memory device included in R0 during read operations, mode register(s) 103 for these memory devices may be reprogrammed to change the resistance setting to either 40 ohms or 120 ohms according to table 240 of register coding scheme 200. Also, RTT_NOM_WR for a memory device included in R0 may include mode registers such as mode register(s) 103 being initially programmed based on table 330 to have a resistance of 240 ohms that may be negatively impacting signal integrity for memory devices included in R0 during write operations. In order to improve signal integrity for memory devices included in R0 during read operations, mode registers such as mode register(s) 103 for these memory devices may be reprogrammed to change a resistance setting of below 240 ohms according to table 240 of register coding scheme 200.

According to some examples, timing diagram 400 shows a Read-0 command on the command (CMD) bus that is directed or targeted to D0 and rank 0 (D0 R0 CS0) followed by a Write-0 command that is targeted to the same rank. For these examples, values for tODTLon WR, tODTLoff WR, tODTLon_WR_NT, and tODTLoff_WR_NT may be based on values programmed or stored to mode registers such as mode register(s) 103 for write commands according to respective tables 310, 320, 330 and 340 of register coding scheme 300. Also, tODTLon RD, tODTLoff RD, tODTLon_RD_NT and tODTLoff_RD_NT may be based on values programmed or stored to mode register(s) 103 for read commands according to respective tables 350, 360, 370 and 380 of register coding scheme 300.

According to some examples, values to establish settings for tODTLon/off may be changed via programming of different values to mode register(s) 103 to further improve signal integrity for memory devices included in R0 during read operations. For example, when a read command is signaled based on D0 R0 CS0 a read line (RL) may be activated for memory devices included in R0 and this may initiate timers for memory devices included in targeted rank R0 for tODTLon_RD and tODTLoff RD and included in non-targeted rank R1 for tODTLon_RD_NT and tODTLoff_RD_NT. A setting for tODTLon RD may indicate an amount of time before an ODT resistance value for RTT_RD is activated. A setting for tODTLoff RD may indicate an amount of time before the ODT resistance value for RTT_RD is deactivated or disabled. A setting for tODTLon_RD_NT may indicate an amount of time before an ODT resistance value for RTT_NOM_RD is activated or enabled after the RL is activated. A setting for tODTLoff_RD_NT may indicate an amount of time before the ODT resistance value for RTT_NOM_RD is deactivated or disabled.

According to some examples, if the settings for tODTLon_RD_NT or tODTLoff_RD_NT are either too short or too long, the signal integrity for memory devices included in R0 may be negatively impacted during read operations. If negatively impacted, mode registers such as mode register(s) 103 included in these memory devices may be reprogrammed from a default timing value (e.g., 10 clock units) to push-out (+ values) or pull-in (- values) a length of time from a default timing value of tODTLon_RD_NT according to table 370 and/or a default timing value for tODTLoff RD_NT according to table 380 of register coding scheme 300 shown in FIG. 3. This reprogramming may cause RTT_NOM_RD to either be compressed (less clock units) or expanded (more clock units) in timing diagram 400 for read commands targeted to memory devices included in R0.

In some examples, if the settings for tODTLon_RD or tODTLoff_RD are either too short or too long, the signal integrity for memory devices included in R0 may also be negatively impacted during read operations. If negatively impacted, mode registers such as mode register(s) 103 included in these memory devices may be reprogrammed from a default timing value to push-out (+ values) or pull-in (- values) a length of time from a default timing value of tODTLon_RD according to table 350 and/or a default timing value for tODTLoff RD according to table 360 of register coding scheme 300 shown in FIG. 3. This reprogramming may cause RTT_RD to either be compressed (less clock units) or expanded (more clock units) in timing diagram 400 for read commands targeted to memory devices included in R0.

According to some examples, settings for tODTLon/off may be changed via programming of different values to mode register(s) 103 to further improve signal integrity for memory device included in R0 during write operations. For example, when a write command is signaled based on D0 R0 CS0 a write line (WL) may be activated for memory devices included in R0 and this may initiate timers for memory devices included in targeted rank R0 for tODTLon_WR and tODTLoff_WR and included in non-targeted rank R1 for tODTLon_WR_NT and tODTLoff_WR_NT. A setting for tODTLon_WR may indicate an amount of time before an ODT resistance value for RTT_WR is activated. A setting for tODTLoff_WR may indicate an amount of time before the ODT resistance value for RTT_WR is deactivated or disabled. A setting for tODTLon_WR_NT may indicate an amount of time before an ODT resistance value for RTT_NOM_WR is activated or enabled after the WL is activated. A setting for tODTLoff_WR_NT may indicate an amount of time before the ODT resistance value for RTT_NOM_WR is deactivated or disabled.

In some examples, if the settings for tODTLon_WR_NT or tODTLoff WR_NT are either too short or too long, the signal integrity for memory device included in R0 may be negatively impacted during write operations. If negatively impacted, mode register(s) 103 may be reprogrammed to change values to push-out (+ values) or pull-in (- values) a length of time for a default timing value for tODTLon_WR_NT according to table 330 and/or a default timing value for tODTLoff WR_NT according to table 340 of register coding scheme 300 shown in FIG. 3. This reprogramming may cause RTT_NOM_WR to either be compressed (less clock units) or expanded (more clock units) in timing diagram 400 for write commands targeted to memory devices included in R0.

According to some examples, if the settings for tODTLon_WR or tODTLoff_WR are either too short or too long, the signal integrity for memory device included in R0 may also be negatively impacted during write operations. If negatively impacted, mode register(s) 103 may be reprogrammed to change values to push-out (+ values) or pull-in (- values) a length of time for a default timing value for tODTLon_WR according to table 310 and/or a default timing value for tODTLoff_WR according to table 320 of register coding scheme 300 shown in FIG. 3. This reprogramming may cause RTT_WR to either be compressed (less clock units) or expanded (more clock units) in timing diagram 400 for write commands targeted to memory devices included in R0.

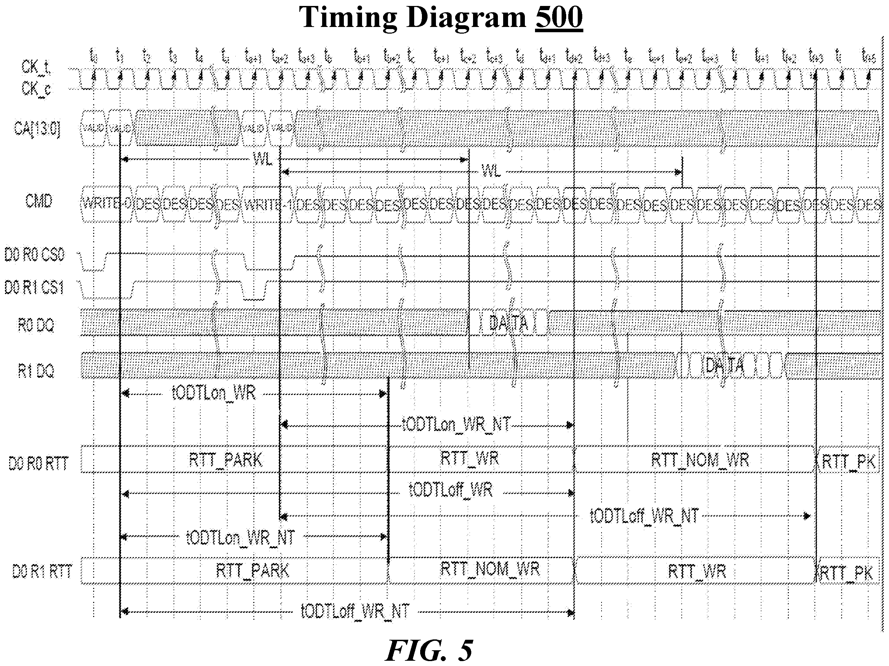

**FIG. 5** illustrates an example timing diagram 500. In some examples, timing diagram 500 as shown in FIG. 5 depicts timing for a write to write turn around for different ranks. For these examples, the different ranks may be for a DIMM (D0) and are shown as R0 and R1. At least some elements of memory device 100 shown in FIG. 1 may be used to describe actions taken in relation to timing diagram 500. Examples are not limited to elements of memory device 100 for timing diagram 500.

Similar to what was mentioned for FIG. 4, values to establish settings for RTT PARK, RTT_WR and RTT_NOM_WR may be programmed or stored to mode registers such as mode register(s) 103. These values may be changed via programming of different values maintained in mode register(s) according to respective tables 210, 220, 230 and 240 of register coding scheme 200 as shown in FIG. 2.

According to some examples, timing diagram 500 shows a Write-0 command on the CMD bus that is directed or targeted to D0 and R0 (D0 R0 CS0) followed by a Write-1 command that is targeted to memory device D0 and R1 (D0 R1 CS1). For these examples, values for tODTLon WR, tODTLoff WR, tODTLon WR NT and tODTLoff WR NT may be based on values programmed or stored to mode register(s) 103 for write commands according to respective tables 310, 320, 330 and 340 of register coding scheme 300. As mentioned previously, these values may be changed via programming of different values to mode register(s) 103 according to one or more example register coding scheme(s).

In some examples, similar to timing diagram 400 shown in FIG. 4, values to establish settings for tODTLon/off may be changed via programming of different values to mode register(s) 103 to further improve signal integrity for memory devices included in R0 during write operations. For example, when a write command is signaled based on D0 R0 CS0 a write line (WL) may be activated for memory devices included in R0 and this may initiate timers for targeted rank R0 for tODTLon_WR and tODTLoff_WR. A setting for tODTLon_WR may indicate an amount of time before an ODT resistance value for RTT_WR is activated or enabled after the WL is activated. A setting for tODTLoff_WR may indicate an amount of time before the ODT resistance value for RTT_WR is deactivated or disabled.

According to some examples, if the settings for tODTLon_WR or tODTLoff WR are either too short or too long, the signal integrity for memory devices included in R0 may be negatively impacted during write operations. If negatively impacted, mode register(s) 103 may be reprogrammed from a default timing value to push-out (+ values) or pull-in (- values) a length of time from a default timing value for tODTLon WR according to table 330 and/or a default timing value for tODTLoff WR according to table 340 of register coding scheme 300 shown in FIG. 3. This reprogramming may cause RTT_WR to either be compressed (less clock units) or expanded (more clock units) in timing diagram 400 for write commands targeted to memory devices included in R0.

In some examples, adjustments to settings for tODTLon_WR_NT and tODTLoff_WR_NT, similar to adjustments mentioned above for timing diagram 400, may be made to further improve signal integrity for memory devices included in R0 during write operations. The adjustments may cause RTT_NOM_WR for memory devices included in R0 to either be compressed or expanded when write commands are targeted to memory devices included in R0.

According to some examples, when the targeted rank switches to R1, settings for non-targeted rank R0 and newly targeted rank R1 for tODTLon_WR, tODTLon_WR_NT, tODTLoff WR and tODTLoff WR NT may be initiated when the write line for memory devices included in R1 is activated (tODTLon_WR and tODTLoff WR are not shown in FIG. 5 for R1). If needed, these settings for tODTLon/off may be further adjusted or changed via programming of different values to mode registers such as mode register(s) 103 included in these memory devices to possibly improve signal integrity for memory devices included in R1 during write operations.

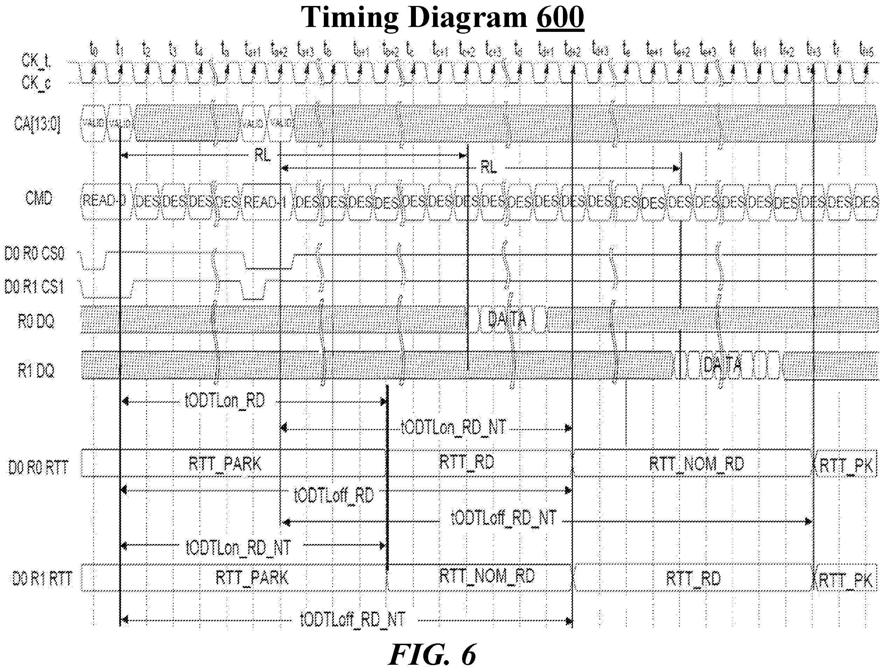

FIG. 6 illustrates an example timing diagram 600. In some examples, timing diagram 600 as shown in FIG. 6 depicts timing for a read to read turn around for different ranks. For these examples, the different ranks may be for a DIMM (D0) and are shown as R0 and R1. At least some elements of memory device 100 shown in FIG. 1 may be used to describe actions taken in relation to timing diagram 600. Examples are not limited to elements of memory device 100 for timing diagram 600.

Similar to what was mentioned for FIG. 4, values to establish setting for RTT_PARK and RTT_NOM_RD may be programmed or stored to mode registers such as mode register(s) 103. These values may be adjusted via programming of different values maintained in these mode register according to respective tables 210, 220, 230 and 240 of register coding scheme 200 as shown in FIG. 2.

According to some examples, timing diagram 600 shows a Read-0 command on the CMD bus that is directed or targeted to D0 and R0 (D0 R0 CS0) followed by a Read-1 command that is targeted to memory device D0 and R1 (D0 R1 CS1). For these examples, values for tODTLon RD, tODTLoff RD, tODTLon_RD_NT and tODTLoff RD_NT may be based on values programmed or stored to mode registers such as mode register(s) 103 for read commands according to respective tables 350, 360, 370 and 380 of register coding scheme 300. As mentioned previously, these values may be changed via programming of different values to mode registers such as mode register(s) 103 according to one or more example register coding scheme(s).

In some examples, similar to timing diagram 400 shown in FIG. 4, values to establish settings for tODTLon/off may be adjusted via programming of different values to mode register(s) 103 to further improve signal integrity for memory devices included in R0 during read operations. For example, when a read command is signaled based on D0 R0 CS0 a read line (RL) may be activated for memory device included in R0 and this may initiate timers for memory devices included in targeted rank R0 for tODTLon_RD and tODTLoff RD and included in non-targeted rank R1 for tODTLon_RD_NT and tODTLoff_RD_NT. As mentioned previously. If the settings for tODTLon RD, tODTLoff_RD tODTLon_RD_NT or tODTLoff_RD_NT are either too short or too long, the signal integrity for memory devices included in R0 may be negatively impacted during read operations. If negatively impacted, mode registers such as mode register(s) 103 may be reprogrammed to push-out (+ values) or pull-in (- values) a length of time for default time values for tODTLon_RD according to table 350, for tODTLoff RD according to table 360, for tODTLon_RD_NT according to table 370 and/or for tODTLoff_RD_NT according to table 380, all shown in FIG. 3. This reprogramming may cause RTT_RD and/or RTT_NOM_RD to either be compressed (less clock units) or expanded (more clock units) in timing diagram 600 for read commands targeted to memory devices included in R0.

According to some examples, as shown in FIG. 6, when the targeted rank switches to R1, settings for non-targeted rank R0 and newly targeted rank R1 for tODTLon_RD, tODTLon RD NT, tODTLoff RD and tODTLoff_RD_NT may be initiated when the read line for memory devices included in R1 is activated (tODTLon_RD and tODTLoff RD are not shown in FIG. 6 for R1). In other words, memory devices included in R0 now become memory devices included in the non-targeted rank. If needed, settings for tODTLon/off may be further adjusted via programming of different values to mode registers such as mode register(s) 103 to possibly improve signal integrity for memory devices included in R1 during read operations.

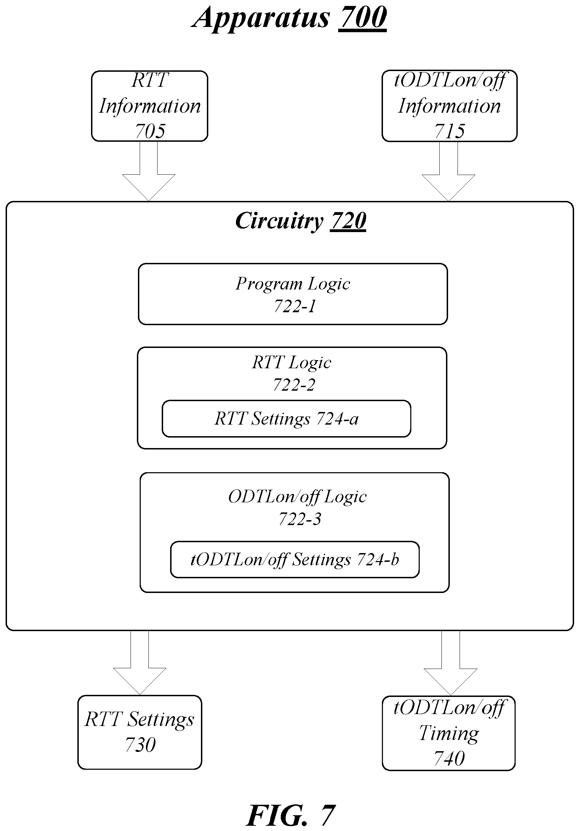

FIG. 7 illustrates an example block diagram for an apparatus 700. Although apparatus 700 shown in FIG. 7 has a limited number of elements in a certain topology, it may be appreciated that the apparatus 700 may include more or less elements in alternate topologies as desired for a given implementation.

The apparatus 700 may be supported by circuitry 720 and apparatus 700 may be a controller or controller logic maintained at a memory device or memory system. The memory device may be maintained on a DIMM that may be coupled to a host computing platform. Circuitry 720 may be arranged to execute one or more software or firmware implemented components, modules or logic 722-*a* (e.g., implemented, at least in part, by a storage controller of a storage device). It is worthy to note that "*a*" and "*b*" and "c" and similar designators as used herein are intended to be variables representing any positive integer. Thus, for example, if an implementation sets a value for *a* = 3, then a complete set of software or firmware for logic, components or modules 722-*a* may include logic 722-1, 722-2 or 722-3. Also, at least a portion of "logic" may be software/firmware stored in computer-readable media, and although the logic is shown in FIG. 7 as discrete boxes, this does not limit logic to storage in distinct computer-readable media components (e.g., a separate memory, etc.).

According to some examples, circuitry 720 may include a processor or processor circuitry. The processor or processor circuitry can be any of various commercially available processors, including without limitation an AMD® Athlon®, Duron® and Opteron® processors; ARM® application, embedded and secure processors; IBM® and Motorola® DragonBall® and PowerPC® processors; IBM and Sony® Cell processors; Intel® Atom®, Celeron®, Core (2) Duo®, Core i3, Core i5, Core i7, Itanium®, Pentium®, Xeon®, Xeon Phi® and XScale® processors; and similar processors. According to some examples circuitry 720 may also include one or more application-specific integrated circuits (ASICs) and at least some logic 722-a may be implemented as hardware elements of these ASICs.

According to some examples, apparatus 700 may include a program logic 722-1. Program logic 722-1 may be a logic and/or feature executed by circuitry 720 to program one or more sets of values to registers at a memory device to establish one or more RTT setting for ODT at the memory device and to establish one or more settings for tODTLon/off. For these examples, one or more sets of values may be RTT values or tODTLon/off values. The values may be based on RTT information 705 or tODTLon/off information 715.

In some examples, apparatus 700 may also include an RTT logic 722-2. RTT logic 722-2 may be a logic and/or feature executed by circuitry 720 to change the one or more of the values programmed by program logic 722-1 that established RTT settings to adjust a signal integrity for the memory device during a read or write operation. For these examples, RTT settings 730 may include the one or more RTT settings that were changed by RTT logic 722-2.

According to some examples, apparatus 700 may also include a tODTLon/off logic 722-3. tODTLon/off logic 722-3 may be a logic and/or feature executed by circuitry 720 to change one or more values programmed by program logic 722-1 to adjust one or more settings for tODTLon/off to adjust a signal integrity for the memory device during a read or write operation. For these examples, tODTLon/off timing 740 may include the one or more tODTLon/off values that were changed by tODTLon/off logic 722-3.

Included herein is a set of logic flows representative of example methodologies for performing novel aspects of the disclosed architecture. While, for purposes of simplicity of explanation, the one or more methodologies shown herein are shown and described as a series of acts, those skilled in the art will understand and appreciate that the methodologies are not limited by the order of acts. Some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all acts illustrated in a methodology may be required for a novel implementation.

A logic flow may be implemented in software, firmware, and/or hardware. In software and firmware embodiments, a logic flow may be implemented by computer executable instructions stored on at least one non-transitory computer readable medium or machine readable medium, such as an optical, magnetic or semiconductor storage. The embodiments are not limited in this context.

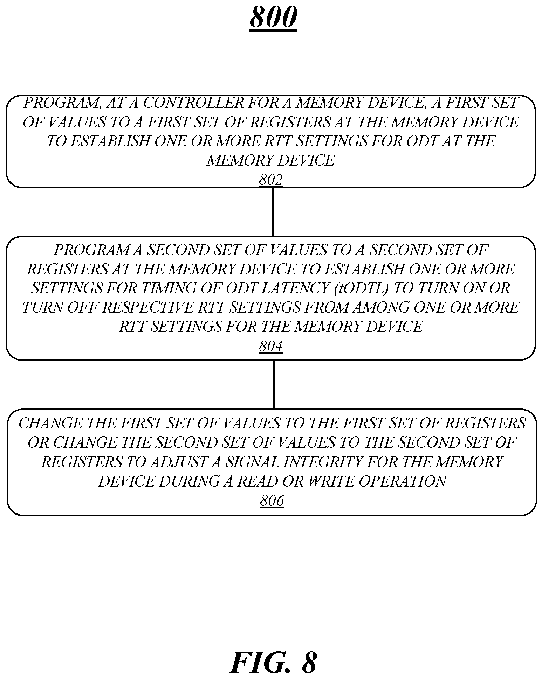

**FIG. 8** illustrates an example of a logic flow 800. Logic flow 800 may be representative of some or all of the operations executed by one or more logic, features, or devices described herein, such as apparatus 800. More particularly, logic flow 800 may be implemented by one or more of program logic 722-1, RTT logic 722-2 or tODTLon/off logic 722-3.

According to some examples, logic flow 800 at block 802 may program, at a controller for a memory device, a first set of values to a first set of registers at the memory device to establish one or more RTT settings for ODT at the memory device. For these examples, program logic 722-1 may program the first set of values to the first set of registers.

In some examples, logic flow 800 at block 804 may program a second set of values to a second set of registers at the memory device to establish one or more settings for timing of ODT latency (tODTL) to turn on or turn off respective RTT settings from among one or more RTT settings for the memory device. For these examples, program logic 722-1 may program the second set of values to the second set of registers.

According to some examples, logic flow 800 at block 806 may change the first set of values to the first set of registers or change the second set of values to the second set of registers to adjust a signal integrity for the memory device during a read or write operation. For these examples, RTT logic 722-2 may change the one or more of the first set of values to adjust the signal integrity and/or tODTLon/off logic 722-3 may change the one or more of the second set of values to also adjust the signal integrity.

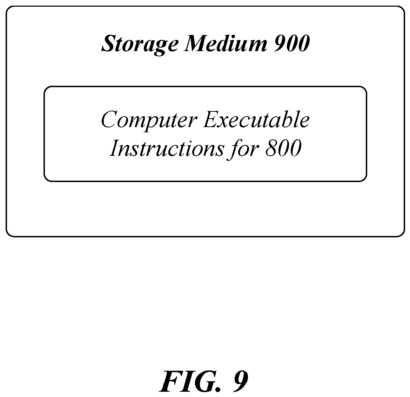

**FIG. 9** illustrates an example of a first storage medium. As shown in FIG. 9, the first storage medium includes a storage medium 900. The storage medium 900 may comprise an article of manufacture. In some examples, storage medium 900 may include any non-transitory computer readable medium or machine readable medium, such as an optical, magnetic or semiconductor storage. Storage medium 900 may store various types of computer executable instructions, such as instructions to implement logic flow 800. Examples of a computer readable or machine readable storage medium may include any tangible media capable of storing electronic data, including volatile memory or non-volatile memory, removable or non-removable memory, erasable or non-erasable memory, writeable or re-writeable memory, and so forth. Examples of computer executable instructions may include any suitable type of code, such as source code, compiled code, interpreted code, executable code, static code, dynamic code, object-oriented code, visual code, and the like. The examples are not limited in this context.

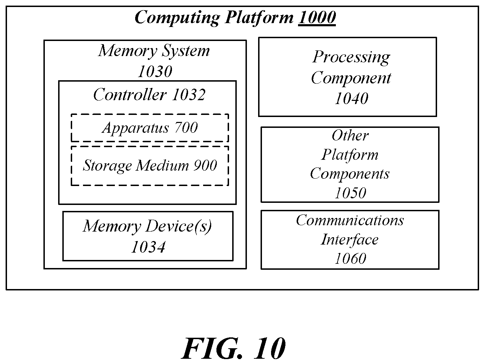

**FIG. 10** illustrates an example computing platform 1000. In some examples, as shown in FIG. 10, computing platform 1000 may include a memory system 1030, a processing component 1040, other platform components 1050 or a communications interface 1060. According to some examples, computing platform 1000 may be implemented in a computing device.

According to some examples, memory system 1030 may include a controller 1032 and memory devices(s) 1034. For these examples, logic and/or features resident at or located at controller 1032 may execute at least some processing operations or logic for apparatus 700 and may include storage media that includes storage medium 900. Also, memory device(s) 1034 may include similar types of volatile or non-volatile memory (not shown) that are described above for memory device 100 shown in FIG. 1. In some examples, controller 1032 may be part of a same die with memory device(s) 1034. In other examples, controller 1032 and memory device(s) 1034 may be located on a same die or integrated circuit with a processor (e.g., included in processing component 1040). In yet other examples, controller 1032 may be in a separate die or integrated circuit coupled with memory device(s) 1034.

According to some examples, processing component 1040 may include various hardware elements, software elements, or a combination of both. Examples of hardware elements may include devices, logic devices, components, processors, microprocessors, circuits, processor circuits, circuit elements (e.g., transistors, resistors, capacitors, inductors, and so forth), integrated circuits, ASIC, programmable logic devices (PLD), digital signal processors (DSP), FPGA/programmable logic, memory units, logic gates, registers, semiconductor device, chips, microchips, chip sets, and so forth. Examples of software elements may include software components, programs, applications, computer programs, application programs, system programs, software development programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given example.

In some examples, other platform components 1050 may include common computing elements, such as one or more processors, multi-core processors, co-processors, memory units, chipsets, controllers, peripherals, interfaces, oscillators, timing devices, video cards, audio cards, multimedia I/O components (e.g., digital displays), power supplies, and so forth. Examples of memory units associated with either other platform components 1050 or storage system 1030 may include without limitation, various types of computer readable and machine readable storage media in the form of one or more higher speed memory units, such as read-only memory (ROM), RAM, DRAM, DDR DRAM, synchronous DRAM (SDRAM), DDR SDRAM, SRAM, programmable ROM (PROM), EPROM, EEPROM, flash memory, ferroelectric memory, SONOS memory, polymer memory such as ferroelectric polymer memory, nanowire, FeTRAM or FeRAM, ovonic memory, phase change memory, memristers, STT-MRAM, magnetic or optical cards, and any other type of storage media suitable for storing information.

In some examples, communications interface 1060 may include logic and/or features to support a communication interface. For these examples, communications interface 1060 may include one or more communication interfaces that operate according to various communication protocols or standards to communicate over direct or network communication links. Direct communications may occur through a direct interface via use of communication protocols or standards described in one or more industry standards (including progenies and variants) such as those associated with the SMBus specification, the PCIe specification, the NVMe specification, the SATA specification, SAS specification or the USB specification. Network communications may occur through a network interface via use of communication protocols or standards such as those described in one or more Ethernet standards promulgated by the IEEE. For example, one such Ethernet standard may include IEEE 802.3-2012, Carrier sense Multiple access with Collision Detection (CSMA/CD) Access Method and Physical Layer Specifications, Published in December 2012 (hereinafter "IEEE 802.3").

Computing platform 1000 may be part of a computing device that may be, for example, user equipment, a computer, a personal computer (PC), a desktop computer, a laptop computer, a notebook computer, a netbook computer, a tablet, a smart phone, embedded electronics, a gaming console, a server, a server array or server farm, a web server, a network server, an Internet server, a work station, a mini-computer, a main frame computer, a supercomputer, a network appliance, a web appliance, a distributed computing system, multiprocessor systems, processor-based systems, or combination thereof. Accordingly, functions and/or specific configurations of computing platform 1000 described herein, may be included or omitted in various embodiments of computing platform 1000, as suitably desired.

The components and features of computing platform 1000 may be implemented using any combination of discrete circuitry, ASICs, logic gates and/or single chip architectures. Further, the features of computing platform 1000 may be implemented using microcontrollers, programmable logic arrays and/or microprocessors or any combination of the foregoing where suitably appropriate. It is noted that hardware, firmware and/or software elements may be collectively or individually referred to herein as "logic", "circuit" or "circuitry."

One or more aspects of at least one example may be implemented by representative instructions stored on at least one machine-readable medium which represents various logic within the processor, which when read by a machine, computing device or system causes the machine, computing device or system to fabricate logic to perform the techniques described herein. Such representations may be stored on a tangible, machine readable medium and supplied to various customers or manufacturing facilities to load into the fabrication machines that actually make the logic or processor.

Various examples may be implemented using hardware elements, software elements, or a combination of both. In some examples, hardware elements may include devices, components, processors, microprocessors, circuits, circuit elements (e.g., transistors, resistors, capacitors, inductors, and so forth), integrated circuits, ASICs, PLDs, DSPs, FPGAs, memory units, logic gates, registers, semiconductor device, chips, microchips, chip sets, and so forth. In some examples, software elements may include software components, programs, applications, computer programs, application programs, system programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation.

Some examples may include an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or non-removable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner or syntax, for instructing a machine, computing device or system to perform a certain function. The instructions may be implemented using any suitable high-level, low-level, object-oriented, visual, compiled and/or interpreted programming language.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.

In addition, in the foregoing Detailed Description, it can be seen that various features are grouped together in a single example for the purpose of streamlining the disclosure. This method of disclosure is not to be interpreted as reflecting an intention that the claimed examples require more features than are expressly recited in each claim. Rather, as the following claims reflect, inventive subject matter lies in less than all features of a single disclosed example. Thus the following claims are hereby incorporated into the Detailed Description, with each claim standing on its own as a separate example. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. An apparatus comprising:
a controller (110) for a memory device (100) that includes logic, at least a portion of which comprises hardware, the logic to:
program a first set of values to a first set of registers (103) at the memory device (100) to establish one or more internal resistance termination, RTT, settings for on die termination. ODT, at the memory device (100), wherein the first set of values include a first resistance value for RTT_PARK, a second resistance value for RTT_WR, a third resistance value for RTT_NOM_WR or a fourth resistance value for RTT_NOM_RD;
program a second set of values to a second set of registers at the memory device (100) to establish one or more settings for timing of ODT latency, tODTL, to turn on or turn off respective RTT settings from among one or more RTT settings for the memory device (100), wherein the second set of values include a first timing value for tODTLon_WR to activate resistance for RTT_WR responsive to a write command targeted to the memory device (100), a second timing value for tODTLoff WR to deactivate resistance for RTT WR responsive to a write command targeted to the memory device (100), a third timing value for tODTLon _WR_NT to activate resistance for RTT_NOM_WR responsive to a write command not targeted to the memory device (100), a fourth timing value for tODTLoff_WR_NT to deactivate resistance for RTT_NOM_WR responsive to a write command not targeted to the memory device (100), a fifth timing value for tODTLon_RD to activate resistance for RTT_RD responsive to a read command targeted to the memory device (100), a sixth timing value for tODTLoff RD to deactivate resistance for RTT_RD responsive to a read command targeted to the memory device (100), a seventh timing value for tODTLon_RD_NT to activate resistance for RTT_NOM_RD responsive to a read command not targeted to the memory device (100), an eighth timing value for tODTLoff WR_NT to deactivate resistance for RTT_NOM_WR responsive to a write command not targeted to the memory device (100);
change the first set of values to the first set of registers or change the second set of values to the second set of registers to adjust a signal integrity for the memory device (100) during a read or write operation.

2. The apparatus of claim 1, comprising the one or more settings for tODTL to turn on or turn off respective RTT settings being based on a clock unit, a separate clock unit including one of an individual clock cycle, a portion of an individual clock cycle or multiple clock cycles.

3. The apparatus of claim 2, the logic to change the second set of values comprises the logic to add or subtract one or more clock units to one or more of the first, second, third, fourth, fifth, sixth, seventh or eighth timing values.

4. The apparatus of claim 1, comprising the first set of registers and the second set of registers included in a mode register for the memory device (100).

5. The apparatus of claim 1, comprising the memory device (100) located at a dual in-line memory module, DIMM, the memory device (100) included in one of multiple ranks of memory devices (100) located at the DIMM

6. The apparatus of claim 5, the DIMM comprises a registered DIMM, RDIMM, a load reduced DIMM, LRDIMM, a fully-buffered DIMM, FB-DIMM, an unbuffered DIMM, UDIMM, or a small outline, SODIMM

7. The apparatus of claim 1, comprising the memory device (100) to include non-volatile memory or volatile memory, wherein the volatile memory includes dynamic random access memory (DRAM), the non-volatile memory includes 3-dimensional cross-point memory, memory that uses chalcogenide phase change material, multi-threshold level NAND flash memory, NOR flash memory, single or multi-level phase change memory, PCM, resistive memory, ovonic memory, nanowire memory, ferroelectric transistor random access memory, FeTRAM, magnetoresistive random access memory. MRAM, memory that incorporates memristor technology, or spin transfer torque MRAM, STT-MRAM

8. A method (800) comprising:
programming (802), at a controller (110) for a memory device (100), a first set of values to a first set of registers at the memory device to establish one or more internal resistance termination, RTT, settings for on die termination, ODT, at the memory device (100), wherein the first set of values including a first resistance value for RTT_PARK, a second resistance value for RTT_WR, a third resistance value for RTT_NOM_WR or a fourth resistance value for RTT_NOM_RD;
programming (804) a second set of values to a second set of registers at the memory device (100) to establish one or more settings for timing of ODT latency, tODTL, to turn on or turn off respective RTT settings from among one or more RTT settings for the memory device (100), wherein the second set of values include a first timing value for tODTLon WR to activate resistance for RTT_WR responsive to a write command targeted to the memory device (100), a second timing value for tODTLoff WR to deactivate resistance for RTT_WR responsive to a write command targeted to the memory device (100), a third timing value for tODTLon _WR_NT to activate resistance for RTT_NOM_WR responsive to a write command not targeted to the memory device (100), a fourth timing value for tODTLoff_WR_NT to deactivate resistance for RTT_NOM_WR responsive to a write command not targeted to the memory device (100), a fifth timing value for tODTLon_RD to activate resistance for RTT_RD responsive to a read command targeted to the memory device (100), a sixth timing value for tODTLoff RD to deactivate resistance for RTT_RD responsive to a read command targeted to the memory device (100), a seventh timing value for tODTLon_RD_NT to activate resistance for RTT_NOM_RD responsive to a read command not targeted to the memory device (100), an eighth timing value for tODTLoff WR_NT to deactivate resistance for RTT_NOM_WR responsive to a write command not targeted to the memory device (100); and
changing (806) the first set of values to the first set of registers or change the second set of values to the second set of registers to adjust a signal integrity for the memory device (100) during a read or write operation.

9. The method of claim 8, comprising the one or more settings for tODTL to turn on or turn off respective RTT settings being based on a clock unit, a separate clock unit including one of an individual clock cycle, a portion of an individual clock cycle or multiple clock cycles.

10. The method of claim 9, changing the second set of values comprises adding or subtracting one or more clock units to one or more of the first, second, third, fourth, fifth, sixth, seventh or eighth timing values.

11. The method of claim 8, comprising the first set of registers and the second set of registers included in a mode register for the memory device (100).

12. The method of claim 8, wherein the memory device is located at a dual in-line memory module, DIMM, the memory device (100) being included in one of multiple ranks of memory devices located at the DIMM

13. A computer readable medium having stored thereon instructions that, when executed, cause a computing system to carry out the method of any of claims 8 to 12.

## Patentansprüche

1. Vorrichtung, aufweisend:
eine Steuerung (110) für eine Speichervorrichtung (100), die Logik umfasst, von welcher wenigstens ein Teil Hardware aufweist, wobei die Logik ist zum:
Programmieren eines ersten Satzes von Werten in einen ersten Satz von Registern (103) an der Speichervorrichtung (100), um eine oder mehrere Innenwiderstandsabschluss-,RTT-,Einstellungen für On-Chip-Abschluss, ODT, an der Speichervorrichtung (100) festzulegen, wobei der erste Satz von Werten einen ersten Widerstandswert für RTT_PARK, einen zweiten Widerstandswert für RTT_WR, einen dritten Widerstandswert für RTT_NOM_WR oder einen vierten Widerstandswert für RTT_NOM_RD umfasst;
Programmieren eines zweiten Satzes von Werten in einen zweiten Satz von Registern an der Speichervorrichtung (100), um eine oder mehrerer Einstellungen zur Zeitvorgabe von ODT-Latenz, tODTL, zum Einschalten oder Ausschalten jeweiliger RTT-Einstellungen unter einer oder mehreren RTT-Einstellungen für die Speichervorrichtung (100) festzulegen, wobei der zweite Satz von Werten einen ersten Zeitvorgabewert für tODTLon_WR zum Aktivieren von Widerstand für RTT_WR in Reaktion auf einen für die Speichervorrichtung (100) bestimmten Schreibbefehl, einen zweiten Zeitvorgabewert für tODTLoff_WR zum Deaktivieren von Widerstand für RTT_WR in Reaktion auf einen für die Speichervorrichtung (100) bestimmten Schreibbefehl, einen dritten Zeitvorgabewert für tODTLon_WR_NT zum Aktivieren von Widerstand für RTT_NOM_WR in Reaktion auf einen nicht für die Speichervorrichtung (100) bestimmten Schreibbefehl, einen vierten Zeitvorgabewert für tODTLoff _WR_NT zum Deaktivieren von Widerstand für RTT_NOM_WR in Reaktion auf einen nicht für die Speichervorrichtung (100) bestimmten Schreibbefehl, einen fünften Zeitvorgabewert für tODTLon _RD zum Aktivieren von Widerstand für RTT_RD in Reaktion auf einen für die Speichervorrichtung (100) bestimmten Lesebefehl, einen sechsten Zeitvorgabewert für tODTLoff _RD zum Deaktivieren von Widerstand für RTT_RD in Reaktion auf einen für die Speichervorrichtung (100) bestimmten Lesebefehl, einen siebten Zeitvorgabewert für tODTLon _RD_NT zum Aktivieren von Widerstand für RTT_NOM_RD in Reaktion auf einen nicht für die Speichervorrichtung (100) bestimmten Lesebefehl, einen achten Zeitvorgabewert für tODTLoff _WR_NT zum Deaktivieren von Widerstand für RTT_NOM_WR in Reaktion auf einen nicht für die Speichervorrichtung (100) bestimmten Lesebefehl;
Ändern des ersten Satzes von Werten in den ersten Satz von Registern oder Ändern des zweiten Satzes von Werten in den zweiten Satz von Registern, um eine Signalintegrität für die Speichervorrichtung (100) während einer Lese- oder Schreiboperation anzupassen.

2. Vorrichtung nach Anspruch 1, aufweisend, dass die eine oder die mehreren Einstellungen für tODTL zum Einschalten oder Ausschalten jeweiliger RTT-Einstellungen auf einer Takteinheit basieren, wobei eine separate Takteinheit einen von einem einzelnen Taktzyklus, einem Teil eines einzelnen Taktzyklus oder mehrere Taktzyklen umfasst.

3. Vorrichtung nach Anspruch 2, wobei, dass die Logik den zweiten Satz von Werten ändert, aufweist, dass die Logik eine oder mehrere Takteinheiten zu einem oder mehreren des ersten, des zweiten, des dritten, des vierten, des fünften, des sechsten, des siebten oder des achten Zeitvorgabewerts addiert oder davon subtrahiert.

4. Vorrichtung nach Anspruch 1, umfassend, dass der erste Satz von Registern und der zweite Satz von Registern in einem Modusregister der Speichervorrichtung (100) umfasst sind.

5. Vorrichtung nach Anspruch 1, umfassend, dass die Speichervorrichtung (100) sich an einem doppelreihigen Speichermodul, DIMM, befindet, wobei die Speichervorrichtung (100) in einem von mehreren Ranks von Speichervorrichtungen (100) umfasst ist, die sich am DIMM befinden.

6. Vorrichtung nach Anspruch 5, wobei das DIMM ein registriertes DIMM, RDIMM, ein lastreduziertes DIMM, LRDIMM, ein voll gepuffertes DIMM, FB-DIMM, ein ungepuffertes DIMM, UDIMM, oder ein Small-Outline-DIMM, SODIMM, aufweist.

7. Vorrichtung nach Anspruch 1, aufweisend, dass die Speichervorrichtung (100) einen nichtflüchtigen oder einen flüchtigen Speicher umfasst, wobei der flüchtige Speicher einen dynamischen Direktzugriffsspeicher (DRAM) umfasst, der nichtflüchtige Speicher einen 3D-XPoint-Speicher, einen Speicher, der Chalkogenid-Phasenwechselmaterial verwendet, einen NAND-Flash-Speicher mit Mehrfachschwellenebenen, einen NOR-Flash-Speicher, Ein- oder Mehrebenen-Phasenwechselspeicher, PCM, einen resistiven Speicher, einen Ovonic-Speicher, einen Nanodrahtspeicher, einen Direktzugriffsspeicher mit ferroelektrischem Transistor, FeTRAM, einen magnetoresistiven Direktzugriffsspeicher, MRAM, einen Speicher, der Memristor-Technologie umfasst, oder einen MRAM mit Spin-Übertragungsmoment, STT-MRAM, umfasst.

8. Verfahren (800), aufweisend:
Programmieren (802) an einer Steuerung (110) für eine Speichervorrichtung (100) eines ersten Satzes von Werten in einen ersten Satz von Registern an der Speichervorrichtung, um eine oder mehrere Innenwiderstandsabschluss-,RTT-,Einstellungen für On-Chip-Abschluss, ODT, an der Speichervorrichtung (100) festzulegen, wobei der erste Satz von Werten einen ersten Widerstandswert für RTT_PARK, einen zweiten Widerstandswert für RTT_WR, einen dritten Widerstandswert für RTT_NOM_WR oder einen vierten Widerstandswert für RTT_NOM_RD umfasst,
Programmieren (804) eines zweiten Satzes von Werten in einen zweiten Satz von Registern an der Speichervorrichtung (100), um eine oder mehrerer Einstellungen zur Zeitvorgabe von ODT-Latenz, tODTL, zum Einschalten oder Ausschalten jeweiliger RTT-Einstellungen unter einer oder mehreren RTT-Einstellungen für die Speichervorrichtung (100) festzulegen, wobei der zweite Satz von Werten einen ersten Zeitvorgabewert für tODTLon_WR zum Aktivieren von Widerstand für RTT_WR in Reaktion auf einen für die Speichervorrichtung (100) bestimmten Schreibbefehl, einen zweiten Zeitvorgabewert für tODTLoff_WR zum Deaktivieren von Widerstand für RTT_WR in Reaktion auf einen für die Speichervorrichtung (100) bestimmten Schreibbefehl, einen dritten Zeitvorgabewert für tODTLon_WR_NT zum Aktivieren von Widerstand für RTT_NOM_WR in Reaktion auf einen nicht für die Speichervorrichtung (100) bestimmten Schreibbefehl, einen vierten Zeitvorgabewert für tODTLoff_WR_NT zum Deaktivieren von Widerstand für RTT_NOM_WR in Reaktion auf einen nicht für die Speichervorrichtung (100) bestimmten Schreibbefehl, einen fünften Zeitvorgabewert für tODTLon_RD zum Aktivieren von Widerstand für RTT_RD in Reaktion auf einen für die Speichervorrichtung (100) bestimmten Lesebefehl, einen sechsten Zeitvorgabewert für tODTLoff_RD zum Deaktivieren von Widerstand für RTT_RD in Reaktion auf einen für die Speichervorrichtung (100) bestimmten Lesebefehl, einen siebten Zeitvorgabewert für tODTLon_RD_NT zum Aktivieren von Widerstand für RTT_NOM_RD in Reaktion auf einen nicht für die Speichervorrichtung (100) bestimmten Lesebefehl, einen achten Zeitvorgabewert für tODTLoff_WR_NT zum Deaktivieren von Widerstand für RTT_NOM_WR in Reaktion auf einen nicht für die Speichervorrichtung (100) bestimmten Lesebefehl; und
Ändern (806) des ersten Satzes von Werten in den ersten Satz von Registern oder Ändern des zweiten Satzes von Werten in den zweiten Satz von Registern, um eine Signalintegrität für die Speichervorrichtung (100) während einer Lese- oder Schreiboperation anzupassen.

9. Verfahren nach Anspruch 8, aufweisend, dass die eine oder die mehreren Einstellungen für tODTL zum Einschalten oder Ausschalten jeweiliger RTT-Einstellungen auf einer Takteinheit basieren, wobei eine separate Takteinheit einen von einem einzelnen Taktzyklus, einem Teil eines einzelnen Taktzyklus oder mehrere Taktzyklen umfasst.

10. Verfahren nach Anspruch 9, wobei das Ändern des zweiten Satzes von Werten ein Addieren oder Subtrahieren einer oder mehrerer Takteinheiten zu bzw. von einem oder mehreren des ersten, des zweiten, des dritten, des vierten, des fünften, des sechsten, des siebten oder des achten Zeitvorgabewerts aufweist.

11. Verfahren nach Anspruch 8, aufweisend, dass der erste Satz von Registern und der zweite Satz von Registern in einem Modusregister der Speichervorrichtung (100) umfasst sind.

12. Verfahren nach Anspruch 8, wobei die Speichervorrichtung sich an einem doppelreihigen Speichermodul, DIMM, befindet, wobei die Speichervorrichtung (100) in einem von mehreren Ranks von Speichervorrichtungen umfasst ist, die sich am DIMM befinden.

13. Computerlesbares Medium mit darauf gespeicherten Anweisungen, die bei Ausführung ein Computersystem zum Durchführen des Verfahrens nach einem der Ansprüche 8 bis 12 veranlassen.

## Revendications

1. Appareil comprenant :
un dispositif de commande (110) pour un dispositif mémoire (100) qui comprend une logique, dont au moins une partie comprend du matériel, la logique étant destinée à :
programmer un premier ensemble de valeurs dans un premier ensemble de registres (103) au niveau du dispositif mémoire (100) pour établir un ou plusieurs réglages de terminaison de résistance interne, RTT, pour la terminaison sur puce ODT, au niveau du dispositif mémoire (100), le premier ensemble de valeurs comprenant une première valeur de résistance pour RTT_PARK, une deuxième valeur de résistance pour RTT_WR, une troisième valeur de résistance pour RTT_NOM_WR ou une quatrième valeur de résistance pour RTT_NOM_RD ;
programmer un deuxième ensemble de valeurs dans un deuxième ensemble de registres au niveau du dispositif mémoire (100) pour établir un ou plusieurs réglages pour une temporisation de latence d'ODT, tODTL, pour activer ou désactiver des réglages RTT respectifs parmi un ou plusieurs réglages RTT pour le dispositif mémoire (100), le deuxième ensemble de valeurs comprenant une première valeur de temporisation pour tODTLon_WR pour activer une résistance pour RTT_WR en réponse à une commande d'écriture ciblée sur le dispositif mémoire (100), une deuxième valeur de temporisation pour tODTLoff_WR pour désactiver une résistance pour RTT_WR en réponse à une commande d'écriture ciblée sur le dispositif mémoire (100), une troisième valeur de temporisation pour tODTLon_WR_NT pour activer une résistance pour RTT_NOM_WR en réponse à une commande d'écriture non ciblée sur le dispositif mémoire (100), une quatrième valeur de temporisation pour tODTLoff_WR_NT pour désactiver une résistance pour RTT_NOM_WR en réponse à une commande d'écriture non ciblée sur le dispositif mémoire (100), une cinquième valeur de temporisation pour tODTLon_RD pour activer une résistance pour RTT_RD en réponse à une commande de lecture ciblée sur le dispositif mémoire (100), une sixième valeur de temporisation pour tODTLoff_RD pour désactiver une résistance pour RTT_RD en réponse à une commande de lecture ciblée sur le dispositif mémoire (100), une septième valeur de temporisation pour tODTLon_RD_NT pour activer une résistance pour RTT_NOM_RD en réponse à une commande de lecture non ciblée sur le dispositif mémoire (100), une huitième valeur de temporisation pour tODTLoff_WR_NT pour désactiver une résistance pour RTT_NOM_WR en réponse à une commande d'écriture non ciblée sur le dispositif mémoire (100) ;
modifier le premier ensemble de valeurs pour le premier ensemble de registres ou modifier le deuxième ensemble de valeurs pour le deuxième ensemble de registres afin d'ajuster l'intégrité du signal pour le dispositif mémoire (100) pendant une opération de lecture ou d'écriture.

2. Appareil selon la revendication 1, comprenant le ou les réglages pour l'activation ou la désactivation par tODTL des réglages RTT respectifs, qui sont basés sur une unité d'horloge, une unité d'horloge séparée comprenant un cycle d'horloge individuel, une partie d'un cycle d'horloge individuel ou de multiples cycles d'horloge.

3. Appareil selon la revendication 2, la logique pour modifier le deuxième ensemble de valeurs comprenant la logique pour ajouter ou soustraire une ou plusieurs unités d'horloge à une ou plusieurs des première, deuxième, troisième, quatrième, cinquième, sixième, septième ou huitième valeurs de temporisation.

4. Appareil selon la revendication 1, comprenant le premier ensemble de registres et le deuxième ensemble de registres inclus dans un registre de mode pour le dispositif mémoire (100).

5. Appareil selon la revendication 1, comprenant le dispositif mémoire (100) situé dans un module de mémoire en ligne double, DIMM, le dispositif mémoire (100) étant inclus dans l'un des multiples rangs de dispositifs mémoires (100) situés dans le DIMM.

6. Appareil selon la revendication 5, le DIMM comprenant un DIMM enregistré, RDIMM, un DIMM à charge réduite, LRDIMM, un DIMM à mise en tampon complète, FB-DIMM, un DIMM sans mise en tampon, UDIMM, ou de petit format, SODIMM.

7. Appareil selon la revendication 1, comprenant le dispositif mémoire (100) pour comprendre une mémoire non volatile ou une mémoire volatile, la mémoire volatile comprenant une mémoire vive dynamique (DRAM), la mémoire non volatile comprenant une mémoire à points de croisement tridimensionnelle, une mémoire qui utilise un matériau à changement de phase à base de chalcogénure, une mémoire flash NAND à multi-niveaux de seuil, une mémoire flash NOR, une mémoire à changement de phase à niveau unique ou multi-niveaux, PCM, une mémoire résistive, une mémoire ovonique, une mémoire nanofilaire, une mémoire à accès aléatoire à transistors ferroélectriques, FeTRAM, une mémoire à accès aléatoire magnéto-résistive, MRAM, une mémoire qui intègre la technologie des memristances, ou une MRAM à couple de transfert de spin, STT-MRAM.

8. Procédé (800) comprenant :
la programmation (802), au niveau d'un dispositif de commande (110) pour un dispositif mémoire (100), d'un premier ensemble de valeurs dans un premier ensemble de registres au niveau du dispositif mémoire pour établir un ou plusieurs réglages de terminaison de résistance interne, RTT, pour la terminaison sur puce, ODT, au niveau du dispositif mémoire (100), le premier ensemble de valeurs comprenant une première valeur de résistance pour RTT_PARK, une deuxième valeur de résistance pour RTT_WR, une troisième valeur de résistance pour RTT_NOM_WR ou une quatrième valeur de résistance pour RTT_NOM_RD ;
la programmation (804) d'un deuxième ensemble de valeurs dans un deuxième ensemble de registres au niveau du dispositif mémoire (100) pour établir un ou plusieurs réglages pour une temporisation de latence d'ODT, tODTL, pour activer ou désactiver les réglages RTT respectifs parmi un ou plusieurs réglages RTT pour le dispositif mémoire (100), le deuxième ensemble de valeurs comprenant une première valeur de temporisation pour tODTLon_WR pour activer une résistance pour RTT_WR en réponse à une commande d'écriture ciblée sur le dispositif mémoire (100), une deuxième valeur de temporisation pour tODTLoff_WR pour désactiver une résistance pour RTT_WR en réponse à une commande d'écriture ciblée sur le dispositif mémoire (100), une troisième valeur de temporisation pour tODTLon_WR_NT pour activer une résistance pour RTT_NOM_WR en réponse à une commande d'écriture non ciblée sur le dispositif mémoire (100), une quatrième valeur de temporisation pour tODTLoff_WR_NT pour désactiver une résistance pour RTT_NOM_WR en réponse à une commande d'écriture non ciblée sur le dispositif mémoire (100), une cinquième valeur de temporisation pour tODTLon_RD pour activer une résistance pour RTT_RD en réponse à une commande de lecture ciblée sur le dispositif mémoire (100), une sixième valeur de temporisation pour tODTLoff_RD pour désactiver une résistance pour RTT_RD en réponse à une commande de lecture ciblée sur le dispositif mémoire (100), une septième valeur de temporisation pour tODTLon_RD_NT pour activer une résistance pour RTT_NOM_RD en réponse à une commande de lecture non ciblée sur le dispositif mémoire (100), une huitième valeur de temporisation pour tODTLoff_WR_NT pour désactiver une résistance pour RTT_NOM_WR en réponse à une commande d'écriture non ciblée sur le dispositif mémoire (100) ; et
la modification (806) du premier ensemble de valeurs dans le premier ensemble de registres ou la modification du deuxième ensemble de valeurs dans le deuxième ensemble de registres afin de régler l'intégrité d'un signal pour le dispositif mémoire (100) pendant une opération de lecture ou d'écriture.

9. Procédé selon la revendication 8, comprenant le ou les réglages pour l'activation ou la désactivation par tODTL des réglages RTT respectifs, qui sont basés sur une unité d'horloge, une unité d'horloge séparée comprenant un cycle d'horloge individuel, une partie d'un cycle d'horloge individuel ou de multiples cycles d'horloge.

10. Procédé selon la revendication 9, la modification du deuxième ensemble de valeurs, consistant à ajouter ou à soustraire une ou plusieurs unités d'horloge à une ou plusieurs des première, deuxième, troisième, quatrième, cinquième, sixième, septième ou huitième valeurs de temporisation.

11. Procédé selon la revendication 8, comprenant le premier ensemble de registres et le deuxième ensemble de registres inclus dans un registre de mode pour le dispositif mémoire (100).

12. Procédé selon la revendication 8, le dispositif mémoire étant situé dans un module de mémoire en ligne double, DIMM, le dispositif mémoire (100) étant inclus dans l'un des multiples rangs de dispositifs mémoires situés dans le DIMM.

13. Support lisible par ordinateur sur lequel sont stockées des instructions qui, lorsqu'elles sont exécutées, amènent un système informatique à réaliser le procédé selon l'une quelconque des revendications 8 à 12.
